**Europäisches Patentamt**

**European Patent Office**

**Office européen des brevets**

(11) Veröffentlichungsnummer: **0 353 403**
**A1**

## (12) EUROPÄISCHE PATENTANMELDUNG

(21) Anmeldenummer: **89108456.8**

(22) Anmeldetag: **11.05.89**

(51) Int. Cl.⁴: **H03F 3/217 , H03K 17/10 , H03K 17/08**

(30) Priorität: **07.07.88 DE 3822958**

(43) Veröffentlichungstag der Anmeldung:
**07.02.90 Patentblatt 90/06**

(84) Benannte Vertragsstaaten:
**CH DE FR GB LI**

(71) Anmelder: **AEG Olympia Aktiengesellschaft
Postfach 960
D-2940 Wilhelmshaven(DE)**

(72) Erfinder: **Zeis, Jürgen, Dipl.-Ing. (FH)
Tutzinger Strasse 19
D-1000 Berlin 49(DE)**

(74) Vertreter: **Vogl, Leo, Dipl.-Ing.
AEG Olympia Aktiengesellschaft
Theodor-Stern-Kai 1
D-6000 Frankfurt 70(DE)**

(54) **Modulationsverstärker für hohe Spannungen.**

(57) Modulationsverstärker für hohe Spannungen, welcher aus einem Schaltverstärker und einem aus Speicherdrossel (5) und Siebkondensator (6) aufgebauten Tiefpaßfilter besteht. Der Schaltverstärker enthält einen Hochspannungsgleichstromversorgung (3), einen ersten Hochspannungsschalter (1), eine Freilaufdiode (4) und einen zweiten Hochspannungsschalter (2) parallel zur Freilaufdiode, der im Gegentakt zu dem ersten Hochspannungsschalter arbeitet. Die Hochspannungschalter bestehen aus mehreren in Reihe und/oder parallel geschalteten Halbleiterschaltern, vorzugsweise MOSFETs.

FIG. 3

EP 0 353 403 A1

## Modulationsverstärker für hohe Spannungen

Die Erfindung betrifft einen Modulationsverstärker für hohe Spannungen gemäß Oberbegriff des Patentanspruchs 1. Ein solcher Modulationsverstärker ist beispielsweise in dem Artikel von J. Zeis: "Pulsdauermodulation in AM-Rundfunksendern," Tijdschrift van het Nederlands Elektronica- en Radiogenootschap 44 (1979)3, S. 147-152 beschrieben.

Verstärker dieser Art werden insbesondere als Modulationsverstärker in amplitudenmodulierten Hochleistungs-Rundfunksendern des Lang-, Mittel- und Kurzwellenbereichs eingesetzt, deren RF-Endstufe auch heute noch mit einer zumeist anodenmodulierten Rf-Leistungsröhre ausgerüstet ist, für die Modulationsspannungen bis zu 30-50 KV benötigt werden.

Bewährt haben sich diese Verstärker aber auch als Hochspannungs-Gleichstromversorgungen insbesondere für die Magnetstromversorgung in Teilchenbeschleunigeranlagen.

Ein solcher Verstärker besteht aus einem Schaltverstärker und einem Tiefpaßfilter. Der Schaltverstärker wird durch eine Folge von Impulsen angesteuert, die aus dem modulierenden analogen Niederfrequenz-Eingangssignal abgeleitet werden. Je nach Art des Steuerverfahrens ist dabei die Impuls- oder Schaltfrequenz, d.h. die Anzahl der Impulse pro Zeiteinheit, bei konstanter Impulsdauer und -amplitude proportional zur Amplitude des Eingangssignals oder die Impulsdauer bei konstanter Impulsfrequenz und -amplitude. Im ersten Fall spricht man von der Pulsfrequenzmodulation (PFM) und im zweiten Fall von der Pulsdauermodulation (PDM) wobei in der Praxis der PDM i.a. der Vorzug gegeben wird, u.a. wegen der in der Regel besseren Siebung (Filter mit Polstelle).

Ein solcher, beispielsweise mit pulsdauermodulierten Impulsen angesteuerter Modulationsverstärker ("Pulsdauermodulationsverstärker" oder kurz "PDM-Verstärker") ist aufgrund seines Schaltungsprinzips nur in der Lage, eine Ausgangsspannung $U_A$ an das RF-Teil abzugeben, die kleiner als die Eingangsspannung $U_B$ ist. Der Einstellbereich liegt zwischen 0 und 100 % der Eingangsspannung $U_B$, wobei jeder beliebige Wert von $U_A$ zwischen 0 und 100 % von $U_B$ statisch eingestellt werden kann. Somit hat der Modulationsverstärker eine untere Grenzfrequenz von 0 Hz und damit die Eigenschaft eines Gleichspannungstransformators.

Da der Modulationsverstärker sowohl die Trägerleistung als auch die Modulationsleistung für den RF-Teil des amplitudenmodulierten Senders liefert, muß seine Eingangsspannung $U_B$ gleich der maximalen Anodenspannung der anodenmodulierten RF-Endstufenröhre im RF-Teil sein. Die hohen Anforderungen an einen solchen Verstärker hinsichtlich seiner Ausgangswerte (Leistung, Spannung, Strom etc.) und seiner Qualitätswerte (Klirrfaktor etc.) sowie seines Wirkungsgrades erzwangen bisher den Einsatz von Schaltröhren.

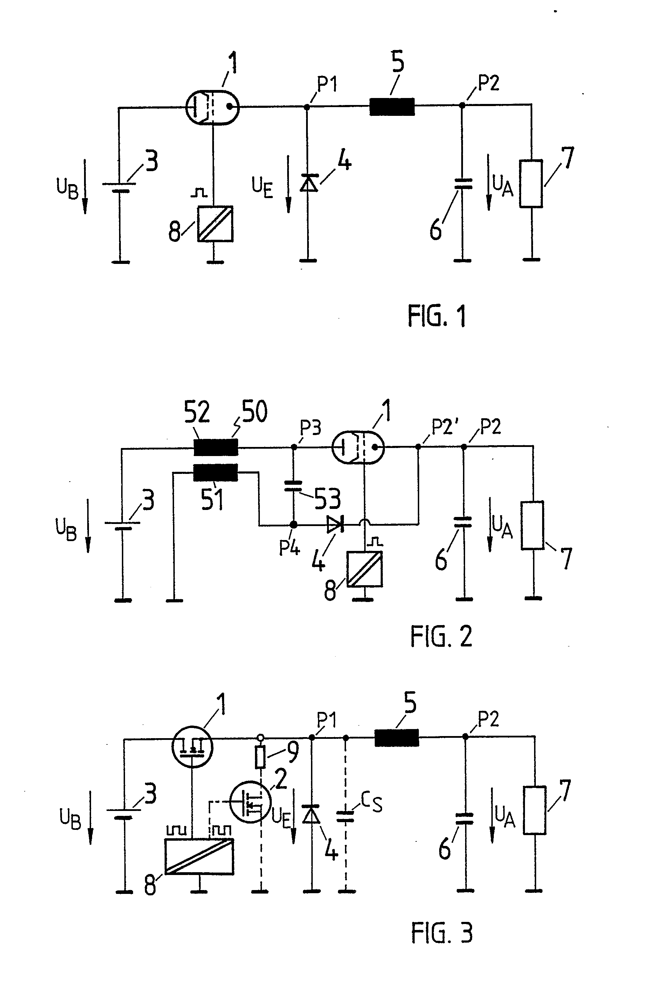

FIG. 1 zeigt die Grundschaltung eines solchen PDM-Verstärkers. Der Leistungsteil besteht aus einer Hochspannungs-Gleichstromversorgung 3, einer Schaltröhre 1, einer Freilaufdiode 4 und einer Speicherdrossel 5, die zusammen mit einem Siebkondensator 6 das Tiefpaßfilter bildet, während die Hochspannungsgleichstromversorgung 3, die Schaltröhre 1 und die Freilaufdiode 4 zusammen mit einer Steuerschaltung 8 den Schaltverstärker bilden. Die Steuerschaltung (8) ist i.a. galvanisch von dem Hauptstromkreis getrennt. Der nachgeschaltete RF-Teil ist der Einfachheit halber durch einen Lastwiderstand 7 ersetzt.

Die Schaltröhre 1 und die Freilaufdiode 4 arbeiten als Umschalter. Schaltet die Röhre 1 ein, dann fließt Strom von der Hochspannungsgleichstromversorgung 3 durch die Röhre 1 und die Speicherdrossel 5 in den Lastwiderstand 7. Dabei wird in der Speicherdrossel 5 Energie gespeichert. Sperrt die Röhre 1, dann verursacht die in der Drossel 5 gespeicherte Energie, daß ein gleich großer Strom durch die Freilaufdiode 4 und die Speicherdrossel 5 in den Widerstand 7 fließt. Die Schaltfrequenz muß nach dem Abtasttheorem dabei mindestens das Zweifache der zulässigen Höchstfrequenz im Frequenzspektrum des Eingangssignals betragen und liegt in der Praxis zwischen 50 und 100 KHz.

Die zwischen Schaltröhre 1 und Freilaufdiode 4 liegende Spannung $U_E$ ändert sich zwischen 0 Volt und Eingangsspannung $U_B$. Das Verhältnis zwischen "Stromversorgungs"-Einschaltzeit $T_{EIN}$ (d.h. die Dauer der Schaltimpulse) und Gesamtzeit der Periodendauer T bestimmt die Höhe der Ausgangsspannung $U_A$ und wird Tastverhältnis $V_T$ oder relative Einschaltzeit genannt. Da die Spannungsflächen $U_B \cdot T$ EIN und $U_A \cdot T$ gleich sind, ändert sich die Ausgangsspannung $U_A$ proportional mit dem Tastverhältnis $V_T$. Die Grenzwerte sind im Idealfall $V_T = 0$ bzw. $U_A = 0$ bei dauernd gesperrter Röhre und $V_T = 1$ bzw. $U_A = U_B$ bei dauernd eingeschalteter Röhre.

Die Speicherdrossel 5 und der Siebkondensator 6 bilden zusammen das Tiefpaßfilter, das von der Spannung $U_E$ nur den Gleichspannungsanteil $U_A$ durchläßt. Die Wechselspannungsanteile der Schaltschwingung und deren Oberwellen werden dagegen im Idealfall gesperrt, in der Praxis stark gedämpft. Deshalb werden i.a. weitere Filterstufen nachgeschaltet, um die Schaltschwingung und deren Oberwellen noch weiter zu dämpfen und damit den Verzerrungsgrad noch weiter zu verringern.

Folglich fließt nur ein Gleichstrom durch die Drossel 5. Die Größe des Stromes wird durch die Ausgangsspannung $U_A$ und den Lastwiderstand 7 bestimmt. Da sich die Ausgangsspannung $U_A$ proportional mit dem Tastverhältnis $V_T$ ändert, ändert sich bei konstanten Lastwiderstand 7 auch der Strom proportional mit $V_T$. Da $V_T$ aber proportional zur Amplitude des modulierenden NF-Eingangssignal ist, ändert sich somit die Ausgangsspannung $U_A$ bzw. der Ausgangsstrom linear mit dem Modulationssignal, obwohl die Schaltröhre 1 nicht als Linearverstärker, sondern als Schalter betrieben wird.

Bilden Röhre 1 und Freilaufdiode 4 einen idealen Umschalter, dann ist bei einem Wicklungswiderstand von $0\Omega$ der Übertragungswirkungsgrad des Modulationsverstärkers 100 %. Durch Umschaltverluste, störende Kapazitäten, Restspannungen und den Drosselwiderstand erreicht man in der Praxis jedoch nur einen Übertragungswirkungsgrad von ca. 95 %.

Die beschriebene Grundschaltung eines PDM-Verstärkers eignet sich hervorragend zum Verständnis dieses Modulationsverfahrens, sie war aber für die Praxis bislang völlig unbrauchbar. Der Grund hierfür besteht im wesentlichen darin, daß an dem Verbindungspunkt P1 zwischen Schaltröhre 1 und Freilaufdiode 4 in FIG. 1 die Spannung $U_E$ mit einer sehr hohen Flankensteilheit (typisch: 30 KV in weniger als 0.1 $\mu$s) anliegt.

Um eine Zusatzbelastung der Röhre 1 zu vermeiden, die mit einer Verschlechterung des Wirkungsgrades und einer Erhöhung des Klirrfaktors einhergeht, muß dieser Verbindungspunkt P1 daher so kapazitätsarm wie möglich sein, denn eine Schaltungskapazität von beispielsweise 100pF verursacht bei einer Spannung von 26 KV und einer Schaltzeit von 0.1 $\mu$s bereits einen Impulsstrom von 26A, was in etwa 20 % der Spitzenstromaussteuerung bei einem Modulationsverstärke für einen 500 kW-Sender ist. Bei der Grundschaltung liegt jedoch an diesem kritischen Punkt P1 die Kathode der Schaltröhre mit den Schaltungskapazitäten des Heiztransformators und des Netztransformators für das Schirmgitternetzgerät und die Treiberstufe, so daß mit dieser Schaltung in der Praxis störende Schaltungskapazitäten in der oben angeführten Größenordnung ohne weiteres erreicht werden.

Zur Lösung dieses Problems wurde bereits vorgeschlagen, die Schaltröhre 1 an den an Masse liegenden Pol der Hochspannungs-Stromversorgung 3 anzuschließen, da die Schaltspannung $U_E$ dann an der Anode der Röhre anliegen würde. Dem Vorteil einer einfacheren Ansteuerung der Röhre (da die Kathode an Masse liegt) steht bei dieser Schaltung der viel größere Nachteil gegenüber, daß der RF-Teil am potentialmäßig hochliegenden Pol der Stromversorgung liegt, wodurch es zumindest bei Kurzwellensendern schwierig wird, die Kathoden und Gitter der RF-Röhren ausreichend niederohmig und störresonanzfrei auf Masse zu beziehen, so daß auch diese Schaltung eine in der Praxis nicht brauchbare Lösung darstellt.

Zur Lösung dieses Problems wurde die in FIG. 2 gezeigt Ausführungsform eines PDM-Verstärkers vorgeschlagen, bei der der Lastwiderstand 7 auf Masse bezogen ist und die Schaltspannung $U_E$ nicht mehr an der Kathode der Schaltröhre 1 liegt.

Ersetzt man nämlich die Speicherdrossel 5 in FIG. 1 durch eine Speicherspule 50 mit zwei galvanisch getrennten und induktiv gut gekoppelten Wicklungen 51, 52, dann kann man die Schaltröhre 1 und die Freilaufdiode 4 getrennt an die Speicherspule 50 anschließen, wobei in FIG. 3 die Speicherspule 50 mit der einen Wicklung 52 zwischen den hochliegenden Pol der Hochspannungsgleichstromversorgung 3 und Schaltröhre 1 bzw. mit der anderen Wicklung 51 zwischen Masse und Freilaufdiode 4 geschaltet ist. Der Kondensator 53 zwischen den Punkten P3 und P4 verbessert die Kopplung der beiden Wicklungen 51, 52 der Speicherspule 50. Im übrigen ist mit 8 wieder die Steuerschaltung und mit 6 der Siebkondensator bezeichnet.

Schaltet die Röhre 1 ein, dann fließt Strom von der Gleichstromversorgung 3 nur durch die eine Wicklung 52 der Speicherspule 50 zum Lastwiderstand 7. Dabei wird in der Spule 50 Energie gespeichert. Sperrt die Röhre, dann fließt der Strom weiter durch die andere Wicklung 51 der Spule 50 und durch die Freilaufdiode 4 zum Lastwiderstand 7. Die Kathoden der Schaltröhre 1 und der Freilaufdiode 4 sind an den Verbindungspunkt P2' zusammengefaßt, an dem die Ausgangsspannung $U_A$ (und nicht die Schaltspannung $U_E$) anliegt. Die steilflankige Schaltspannung $U_E$ liegt bei dieser Schaltung an den Anoden der Schaltröhre 1 bzw. Freilaufdiode 4 (Punkte P3, P4), der die Ausgangsspannung $U_A$ überlagert ist. An der Röhrenanode (Punkt P3) kommt zusätzlich noch die Versorgungsspannung $U_B$ hinzu.

Der prinzipielle Nachteil dieser in der Praxis bewährten Schaltung besteht zum einen darin, daß die Schaltröhre 1 ein verschleißbehaftetes teures Bauelement ist und daher aus Gründen der Zuverlässigkeit in regelmäßigen Abständen (i.a. jährlich) gegen eine neue Röhre ausgetauscht werden muß, was mit erheblichen Anschaffungs- und Wartungskosten verbunden ist, und zum anderen in der aufwendigen Konstruktion der Speicherspule 5, was sich insbesondere in den Herstellungskosten niederschlägt.

In der DE-A1-30 44 956 bzw. in der EP-A1-0 066 904 wurde deshalb ein Modulationsverstärker für hohe Spannungen vorgeschlagen, der mit Halbleiter-Schaltern aufgebaut ist und der aus N gleichartigen und unabhängig voneinander ansteuerbaren Einzel-Schaltverstärkern geringerer Ausgangsspannung besteht, die zur Aufsummierung ihrer Ausgangsspannungen ausgangsseitig in Reihe geschaltet sind und denen ebenfalls ein Tiefpaßfilter nachgeschaltet ist.

Bei dieser Lösung wird der Eingangssignalbereich in N gleiche Spannungsbereiche unterteilt, das momentan anliegende Eingangssignal abgetastet und festgestellt, durch wieviele Spannungsbereiche der momentan anliegende Amplitudenwert des Eingangssignals dargestellt wird. Entsprechend dieser Zahl wird eine gleiche Zahl von Einzel-Schaltverstärkern eingeschaltet, so daß als Summenspannung am Ausgang ein entsprechend verstärktes Eingangssignal in quantisierter Form erzeugt wird, das nach Glättung in dem nachgeschalteten Tiefpaßfilter das entsprechend verstärkte Eingangssignal approximiert.

Der prinzipielle Nachteil dieser Lösung besteht zum einen darin, daß mit der quantisierten Verstärkung des Eingangssignals ein systematischer Quantisierungsfehler verbunden ist, der für zusätzliche Verzerrungen in der Ausgangsspannung des Verstärkers verantwortlich ist und der nur mit erhöhten Filteraufwand zu reduzieren ist, und zum anderen darin, daß ein solcher Verstärker konstruktiv sehr aufwendig ist, da komplette Einzel-Schaltverstärker gebaut werden müssen, und daß dieser Aufwand mit der Zahl der Einzel-Schaltverstärker steigt.

Die Aufgabe der Erfindung besteht darin, eine Modulationsverstärker der eingangs genannten Art zu schaffen, der, unter wirtschaftlichen und technischen Gesichtspunkten betrachtet, eine praktikable und wenig aufwendige Lösung darstellt.

Die erfindungsgemäße Lösung der Aufgabe ist im Patentanspruch 1 beschrieben. Die übrigen Ansprüche enthalten vorteilhafte Aus- und Weiterbildungen der Erfindung.

Die erfindungsgemäße Lösung besteht darin, die Schaltröhre durch mehrere in Reihe und/oder parallel geschaltete Halbleiterschalter zu ersetzen. Durch diesen Austausch wird in der Praxis der Aufbau eines solchen Modulationsverstärkers stark vereinfacht, da nicht mehr der komplizierte Aufbau gemäß FIG. 2, sondern die Grundschaltung gemäß FIG. 1 realisiert werden kann.

Ein weiterer Vorteil der Erfindung ist, daß die Zuverlässigkeit des Verstärkers durch die Verwendung von Halbleiterschaltern anstelle der verschleißbehafteten Röhre höher ist und daß die Ersatzteil- und Wartungskosten geringer sind, da der (jährliche) Austausch der Schaltröhre beim erfindungsgemäßen Modulationsverstärker entfällt. Die zu mindest in Kurzwellensendern auch in Zukunft benötigte Röhre für die RF-Endstufe kann bei der erfindungsgemäßen Lösung nunmehr rein nach RF-Gesichtspunkten ausgewählt werden. Es braucht nicht mehr eine Röhre verwendet werden, die auch den Anforderungen im Modulationsverstärker gerecht wird.

Ferner entfallen beim erfindungsgemäßen Modulationsverstärker der Heiztransformator, das Schirmgitternetzgerät sowie die aufwendige Treiberstufe für die Schaltröhre, was mit einer entsprechenden Kostenersparnis bei der Herstellung verbunden ist. Eine weitere erhebliche Kostenersparnis kommt dadurch zustande, daß anstelle der bisher erforderlichen Speicherspule mit zwei Wicklungen nunmehr eine herkömmliche Speicherdrossel mit nur einer Wicklung verwendet werden kann.

Schließlich ergibt sich ein weiterer Vorteil aus der Möglichkeit, daß die insbesondere bei Sendern kleinerer Leistung (100 kW und weniger) bei sehr schmalen PDM-Impulsen auftretenden "Unterstrichverzerrungen" durch den Einbau eines zweiten Halbleiterschalters parallel zur Freilaufdiode beseitigt werden können, der im Gegentakt zum Hauptschalter arbeitet. Der Wirkungsgrad wird hierdurch nur unmerklich verschlechtert, da der Strom bei Oberstrich und Träger (d.h. also bei hohen Stromwerten) wegen der kurzen Entladezeiten (die i.a. kürzer sind als die Totzeiten zwischen den Schaltvorgängen der beiden Schalter) über die Speicherdrossel weiterfließt und im Lastwiderstand verbraucht wird und nur bei Unterstrich (d.h. also bei kleinen Stromwerten bzw. bei größeren Entladezeiten) über den zweiten Schalter umgelenkt wird und in einem in Reihe mit dem zweiten Schalter liegenden Widerstand verbraucht wird. Zur Optimierung ist es möglich, die Totzeiten zwischen den Schaltvorgängen der beiden Schalter stromabhängig variabel zu machen, so daß der Zusatzschalter mit Halbleiter-Schaltern kleinerer Schaltleistung aufgebaut werden kann, die aber i.a. kürzere Schaltzeiten und niedrigere Durchlaßwiderstände haben, so daß dadurch die Verluste in dem Zusatzschalter noch weiter verringert werden können.

Diese Schaltungsmöglichkeit bestand bei der bekannten Lösung mit Röhren aus wirtschaftlicher Sicht nicht, da zusätzlich ein Heizungstransformator, ein Schirmgitternetzgerät sowie eine Treiberstufe hätten eingebaut werden müssen. Bei der bekannten Lösung hat man daher durch entsprechende steuerungstechnische Maßnahmen bei Unterstrich, d.h. bei kurzen Schaltimpulsen, die Röhre nicht mehr voll eingeschaltet und dadurch nicht mehr als Schalter, sondern als veränderlicher Widerstand betrieben, was jedoch mit einer entsprechenden Verschlechterung des Wirkungsgrades einherging.

In einer vorteilhaften Ausführungsform der erfindungsgemäßen Lösung werden die einzelnen Halbleiterschalter zu Gruppen zusammengefaßt, die jeweils durch einen gemeinsamen Steuerkanal angesteuert werden, wobei in Gruppen mit in Reihe geschalteten Halbleiter-Schaltern vorzugsweise der potentialmäßig niedrigste Halbleiterschalter über Lichtleitkabel, Trägerfrequenz oder mit Nadelimpulsen angesteuert wird und die übrigen Halbleiterschalter durch eine erfindungsgemäße RC-Beschaltung angesteuert werden. Zur Erhöhung der Zuverlässigkeit wird dabei die Funktion des potentialmäßig obersten Halbleiterschalter jeder Gruppe überwacht, da bei Ausfall eines Halbleiterschalters innerhalb einer Gruppe der potentialmäßig oberste immer mit betroffen ist.

Im folgenden wird die Erfindung anhand der Figuren näher erläutert. Es zeigen:

FIG. 1 die bereits diskutierte und an sich bekannte Grundschaltung eines Modulationsverstärkers für hohe Spannungen mit einer Schaltröhre

FIG. 2 eine bereits diskutierte und an sich bekannte Abwandlung dieser Grundschaltung mit einer Schaltröhre und einer Speicherspule mit zwei Wicklungen

FIG. 3 eine bevorzugte Ausführungsform des erfindungsgemäßen Modulationsverstärkers mit zwei im Gegentakt arbeitenden Halbleiter-Schaltern

FIG. 4 4 Spannungsdiagramme der Ausgangsspannung $U_A$ eines Modulationsverstärkers gemäß FIG. 1 zur Erläuterung der Unterstrichverzerrungen

FIG. 5-10 verschiedene Konfigurationen der erfindungsgemäßen Hochspannungsschalter gemäß FIG. 3

FIG. 11-15 verschiedene erfindungsgemäße Ansteuerungen für die erfindungsgemäßen Hochspannungsschalter gemäß FIG. 3 mit in Reihe geschalteten MOS-Feldeffekttransistoren

FIG. 16-18 drei verschiedene erfindungsgemäße Überwachungsschaltungen für die gemäß den Figuren 12-15 in Reihe geschalteten MOSFETs.

Der erfindungsgemäße Modulationsverstärker für hohe Spannungen in FIG. 3 besteht aus einen Hochspannungsgleichstromversorgung 3, einem Hochspannungsschalter 1, einer Freilaufdiode 4 sowie einer Speicherdrossel 5, die zusammen mit einem nachgeschalteten Siebkondensator 6 das Tiefpaßfilter bilden. Mit 7 ist der Lastwiderstand, mit 8 die Steuerschaltung bezeichnet. Mit $U_B$ ist die Ausgangs-Gleichspannung der Gleichstromversorgung 3 bezeichnet, mit $U_E$ die an den Punkt P1 anliegende Schaltspannung und mit $U_A$ die an Punkt P2 anliegende Verstärker-Ausgangsspannung. Die prinzipielle Funktionsweise des erfindungsgemäßen Modulationsverstärkers ist identisch mit der des an sich bekannten Modulationsverstärkers gemäß FIG. 1.

Die Schaltung unterscheidet sich von der an sich bekannten Grundschaltung gemäß FIG. 1 im wesentlichen dadurch, daß der Hochspannungsschalter 1 keine Schaltröhre mehr ist, sondern aus mehreren in Reihe und/oder parallel geschaltete Halbleiterschaltern aufgebaut ist, die beispielsweise MOS-Feldeffekttransistoren (MOSFET) oder Static-Induction-Transistoren (SIT) sein können.

In der FIG. 3 ist aus Gründen der Übersichtlichkeit stellvertretend für die genannten Schalterarten als Symbol das Schaltzeichen eines MOSFET gezeigt.

Zur Beseitigung der weiter oben diskutierten "Unterstrichverzerrungen", die insbesondere bei Sendern kleinerer Leistung (100 kW und weniger) auftreten, kann in einer Weiterbildung des erfindungsgemäßen Modulationsverstärkers gemäß FIG. 3 ein weiterer Hochspannungsschalter 2 parallel zur Freilaufdiode 4 geschaltet werden, der im Gegentakt mit dem Hauptschalter 1 arbeitet und der in gleicher Weise wie der Hauptschalter 1 aus mehreren in Reihe und/oder parallel geschalteten Halbleiterschaltern aufgebaut ist. Einseitig ist diesem Zusatzschalter 2 ein Verbraucherwiderstand 9 in Reihe geschaltet, wobei vorzugsweise der Zusatzschalter 2 an Masse angeschlossen ist, wodurch die Ansteuerung des Schalters 2 erleichtert wird.

Unterstrichverzerrungen entstehen durch die Auf- und Entladung unerwünschter Schaltungskapazitäten $C_S$ an der mit Schaltimpulsen beaufschlagten Seite der Speicherspule 5. Das Verhalten ist unabhängig davon, ob als Schalter eine Schaltröhre (wie in FIG. 1) oder ein aus Halbleiterschaltern aufgebauter Hochspannungsschalter (wie in FIG. 3) verwendet wird. Die Kapazität $C_S$ wird in beiden Fällen beim Schließen (d.h. leitend Steuern) des Schalters 1 auf $U_B$ (beispielsweise auf 30 kV) aufgeladen und nach dem Öffnen (d.h. sperrend Steuern) des Schalters 1 durch den durch die Speicherspule 5 fließenden Strom entladen. Erst nach vollständiger Entladung des "Kondensators" $C_S$ fließt der Strom in gewünschter Weise durch die Freilaufdiode 4.

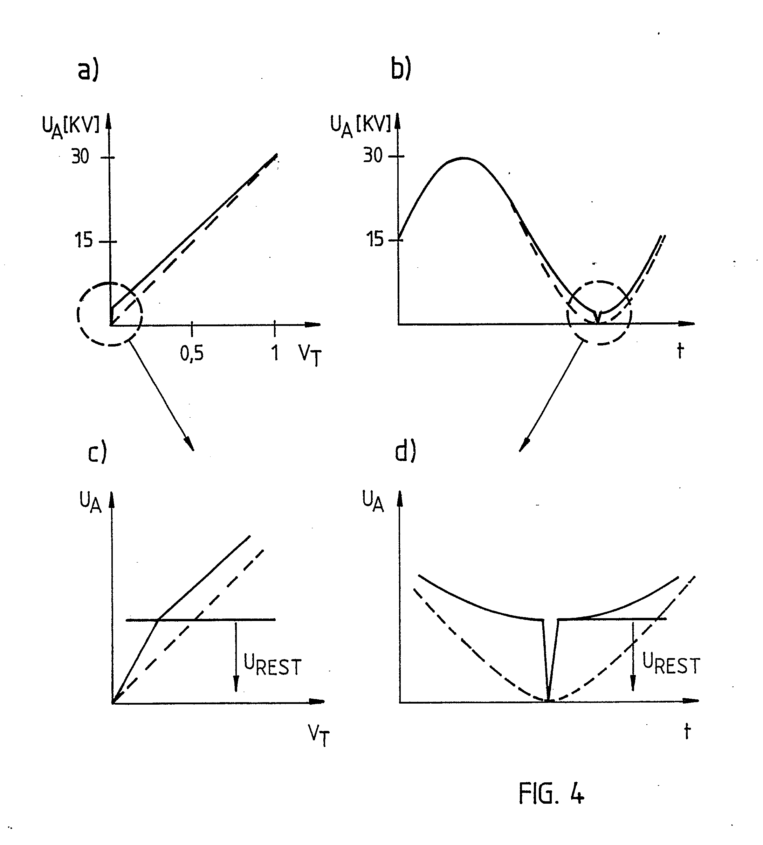

Bei konstantem Lastwiderstand 7 ändern sich, wie weiter oben bereits beschrieben), im Idealfall Ausgangsspannung $U_A$ und Ausgangsstrom am Widerstand linear mit dem Tastverhältniswert $V_T$, d.h. mit dem Verhältnis zwischen Einschaltzeit $T_{EIN}$ des Schalters 1 und Periodendauer T. Durch die Schaltkapazität $C_S$ wird dieser lineare Zusammenhang aufgehoben, so daß, wie in FIG. 4 beispielhaft gezeigt ist, die tatsächliche Ausgangsspannung $U_A$ mit abnehmenden Tastverhältnis $V_T$ zunehmend vom theoretischen Wert (getrichelter Kurvenverlauf in FIG. 4) abweicht. Die Höhe der bei dieser Unterstrichverzerrung verbleibenden Restspannung $U_{REST}$ ist dabei gemäß Gleichung (1) abhängig von der Größe der Kapazität $C_S$:

$$U_{REST} = \sqrt{\frac{1}{2} \, C_S U_E^{\,2} \cdot f_S \cdot R} \qquad\qquad (1)$$

wobei P die Leistung, R der Lastwiderstand, $U_E$ die Schaltspannung, $C_S$ die Schaltungskapazität und $f_S$ die Schaltfrequenz ist.

Für einen 100-KW-Sender ergibt sich nach Gleichung (1) mit $C_S = 100$ pF, $U_E = 30$ kV, $f_S = 50$ kHz und $R = 1$ kΩ eine Restspannung $U_{REST} = 1.5$ kV.

Durch Einbau des Zusatzschalters 2 in FIG. 3, der im Gegentakt zum Hauptschalter 1 betrieben wird, kann die Schaltungskapazität $C_S$ entladen werden. Der Wirkungsgrad des Verstärkers wird hierdurch nur unmerklich verschlechtert, da der Strom bei Oberstrich und Träger (d.h. bei hohen Stromwerten) wegen der kurzen Entladezeiten über die Speicherdrossel 5 weiterfließt und in Lastwiderstand 7 verbraucht wird und nur bei Unterstrich (d.h. bei kleinen Stromwerten und längeren Entladezeiten) über den Zusatzschalter 2 umgelenkt und in den in Reihe mit den Zusatzschalter 2 geschalteten Widerstand 9 verbraucht wird.

Vorteilhaft ist es, die Totzeiten zwischen Öffnen (bzw. Schließen) des Hauptschalters 1 und Schließen (bzw. Öffnen) des Zusatzschalters 2, in Abhängigkeit von den Stromwerten einzustellen, damit der Zusatzschalter mit Halbleiterschaltern kleinerer Schaltleistung aufgebaut werden kann, die i.a. kürzere Schaltzeiten aufweisen, so daß dadurch die Verluste in dem Zusatzschalter noch weiter verringert werden können.

Zur Realisierung der Hochspannungs-Schalter 1 bzw. 2 werden erfindungsgemäß jeweils mehrere Halbleiterschalter in Reihe und/oder parallel geschaltet, wobei sich die Zahl der in Reihe zu schaltenden Halbleiterschalter aus dem Verhältnis der zulässigen Sperrspannung der verwendeten Bauelemente zu der zu schaltenden Hochspannung ergibt und die Zahl der parallel zu schaltenden Halbleiterschalter aus dem Verhältnis des zulässigen Durchlaßstromes der verwendeten Bauelemente zu dem zu schaltenden Gesamtstrom ergibt.

Von den derzeit verfügbaren Bauelementen sind MOSFET am günstigsten, da sich mit ihnen sehr kurze Schaltzeiten erreichen lassen. Außerdem entfallen bei ihnen die für bipolare Bauelemente typischen Speicherzeiten. Ferner ist die Parallelschaltung mehrerer MOSFETs unproblematisch, da sie im Gegensatz zu Bipolartransistoren einen negativen Temperatur gradienten aufweisen, der dazu führt, daß der Durchlaßwiderstand eines MOSFETs mit steigender Temperatur zunimmt und der Durchlaßstrom entsprechend abnimmt, so daß sich der gesamte Strom automatisch gleichmäßig auf die parallel geschalteten Bauelemente aufteilt und eine Überbelastung einzelner Bauelemente dadurch vermieden wird.

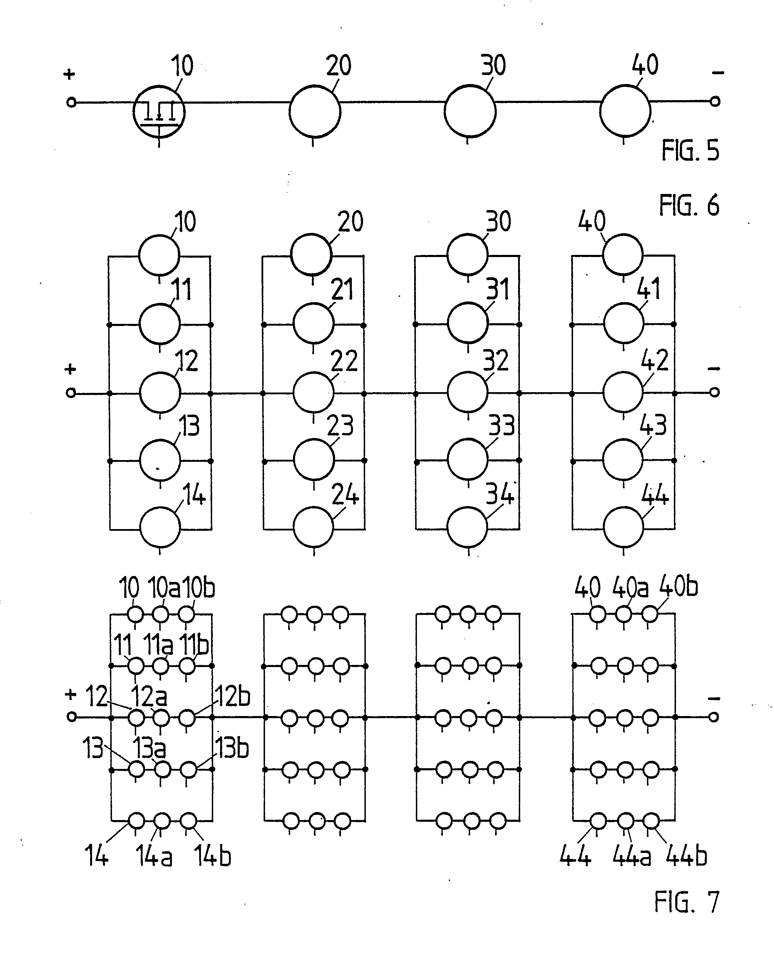

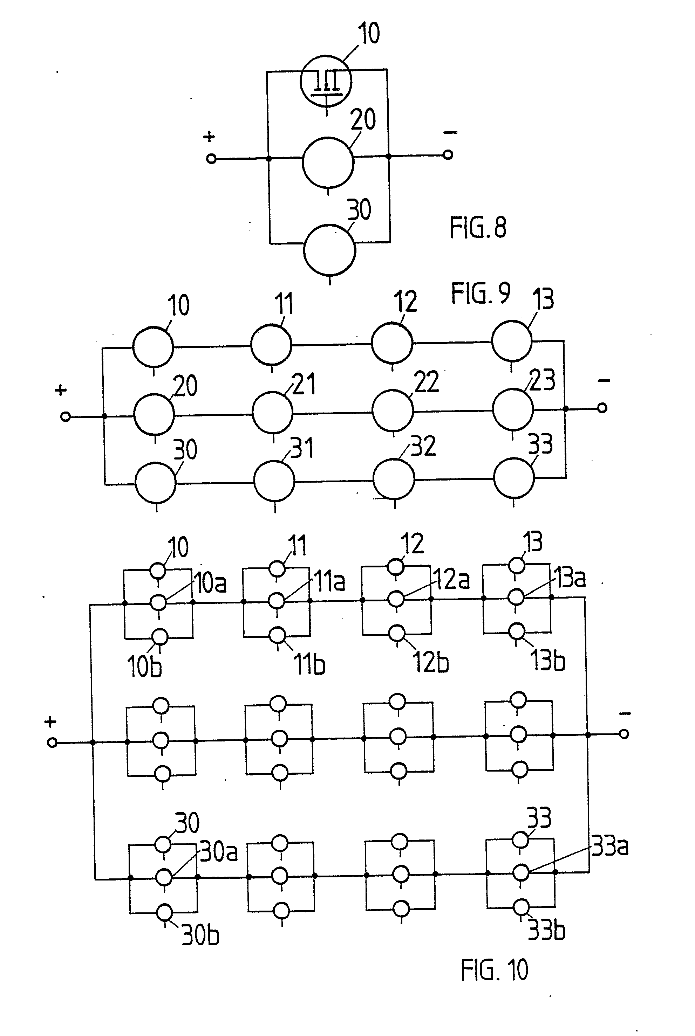

Aus den Grundschaltungen mehrerer in Reihe geschalteter Halbleiterschalter oder mehrerer parallel geschalteter Halbleiterschalter, wie sie in den Figuren 5 und 8 beispielhaft anhand von vier in Reihe bzw. drei parallel geschalteten Bauelementen 10-40 bzw. 10-30 gezeigt sind, lassen sich eine Reihe von Konfigurationen ableiten, die aus Gruppen in Reihe oder parallel geschalteter Halbleiterschalter bestehen, wie z.B. die Konfigurationen in den Figuren 6 und 7, die aus der Reihenschaltung der FIG. 5 abgeleitet sind, oder die in den Figuren 9 und 10, die aus der Parallelschaltung der FIG. 8 abgeleitet sind. In allen Figuren 5-10 sind die einzelnen Halbleiterschalter durch Kreise dargestellt, wobei jeweils ein Kreis in den Figuren 5 und 8 stellvertretend für alle anderen Kreise mit dem Schaltzeichen eines MOSFETs ausgefüllt ist, was jedoch nur als allgemeines Symbol für einen Halbleiterschalter verstanden werden soll.

In FIG. 6 wurden jedem Halbleiterschalter 10-40 der FIG. 5 beispielhaft jeweils vier weitere Schalter 11-14; 21-24; 31-34; 41-44 parallel geschaltet, in FIG. 7 jedem der Halbleiterschalter 10-14; 20-24; 30-34; 40-44 der FIG. 6 beispielhaft jeweils zwei weitere Schalter 10a, b; 11a, b; ..44a, b in Reihe geschaltet. In FIG. 9 wurden jedem Halbleiterschalter 10-30 der FIG. 8 beispielhaft jeweils drei weitere Schalter 11-13; 21-23; 31-33 in Reihe geschaltet, in FIG. 10 jedem der Halbleiterschalter 10-13; 20-23; 30-33 der FIG. 9 beispielhaft jeweils zwei weitere Schalter 10a, b; 11a, b; ...33a, b parallelgeschaltet. Andere Konfigurationen sind selbstverständlich auch möglich.

Welche Schalterkonfigurationen für den Aufbau der Hochspannungsschalter tatsächlich geeignet sind, hängt natürlich von den übrigen Randbedingungen der jeweiligen Anwendung ab.

Die Ansteuerung der Halbleiterschalter kann erfindungsgemäß so erfolgen, daß zu jedem einzelnen Halbleiterschalter der beiden Hochspannungsschalter 1 und 2 in FIG. 3 jeweils eine separate Steuerleitung der Steuerschaltung 8 führt. Die Halbleiterschalter können aber auch in Gruppen zusammengefaßt werden, zu denen jeweils nur eine Steuerleitung der Steuerschaltung 8 in FIG. 3 führt. Enthalten die Gruppen dabei mehrere in Reihe geschaltete Halbleiterschalter, wird vorteilhafterweise nur der Halbleiterschalter der Gruppe durch die der Gruppe zugeordneten Steuerleitung direkt ausgesteuert, der potentialmäßig dem Minus-Bezugspotential der Gruppe am nächsten liegt, während die übrigen Halbleiterschalter dieser Reihenschaltung über einen RC-Spannungsteiler angesteuert werden.

Wegen der hohen Spannungen ist es vielfach zwingend erforderlich, die Steuerschaltung 8 galvanisch von den Hochspannungsschalter 1 und 2 in FIG. 3 zu trennen. Dies kann beipielsweise dadurch geschehen, daß in den einzelnen Steuerleitungen von der Steuerschaltung zu den Halbleiterschaltern bzw. Halbleiterschalter-Gruppen Impulsübertrager eingebaut werden. Eine andere gängige Methode ist die Übertragung der Steuerimpulse über Lichtleitkabel, wobei i.a. an den beiden Enden des Kabels jeweils ein elektrooptischer Wandler angebracht ist, mit denen die elektrische Steuersignale in optische Steuersignale umgewandelt werden und umgekehrt.

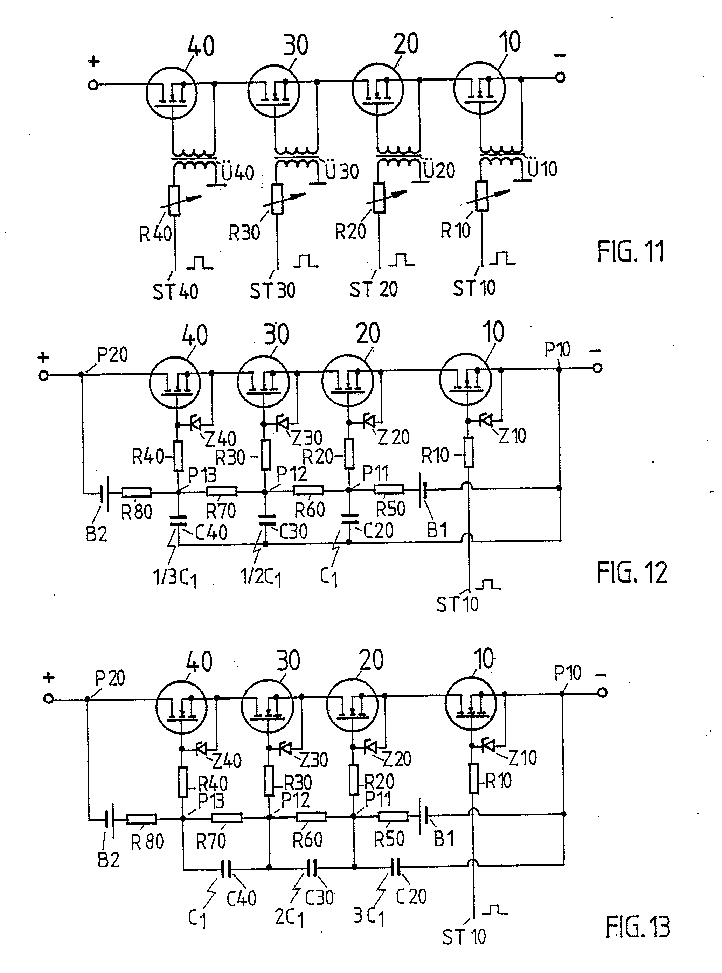

Bevorzugte Ausführungsformen der erfindungsgemäßen Steuerschaltung für in Reihe geschaltete MOSFETs sind in den Figuren 11-15 gezeigt.

In Figur 11 sind beispielhaft vier in Reihe geschaltete MOSFETs 10-40 gezeigt. Jeder dieser MOSFETs 10-40 ist mit seiner Gate-Elektrode an eine ihm zugeordnete Steuerleitung ST10-ST40 angeschlossen. Zur galvanischen Trennung ist dabei jeweils ein Übertrager, vorzugsweise ein Ringkern-Übertrager Ü10-Ü40 in den Steuerleitungen ST10-ST40 vorgesehen, dessen Sekundärwicklung mit dem einem Ende an die Gate-Elektrode und mit dem anderen Ende an die Source-Elektrode des zugeordneten MOSFETs 10-40 angeschlossen ist und dessen Primärwicklung mit dem einen Ende an Masse und mit dem anderen Ende an die zugeordnete Steuerleitung ST10-ST40 angeschlossen ist. Zur Einstellung der Sperrspannungsaufteilung zwischen den einzelnen MOSFETs 10-40 ist in jeder Steuerleitung ST10-ST40 zusätzlich noch ein in seinem Wert variabel einstellbarer Widerstand R10-R40 eingebaut, der in Reihe mit der Primärwicklung des zugeordneten Übertragers Ü10-Ü40 liegt.

Zur Synchronisierung der Schaltzeitpunkte der einzelnen MOSFETs 10-40 kann außerdem noch in jeder Steuerleitung ST10-ST40 ein (in der Figur nicht gezeigtes) variabel ein stellbares Zeitverzögerungsglied eingebaut werden, daß vorzugsweise ebenfalls mit der Primärwicklung des zugeordneten Übertragers Ü10-Ü40 in Reihe geschaltet ist.

Mit einer solchen Ansteuerung wird eine sehr gleichmäßige Sperrspannungsaufteilung zwischen den einzelnen MOSFETs erreicht. Auch sind die Schaltzeitpunkte der einzelnen MOSFETs mit dieser Ansteuerung gut zu synchronisieren, so daß kurze Schaltzeiten des Hochspannungsschalters realisierbar sind. Schließlich kann mit dieser Schaltung die störende Restspannung an den durchgeschalteten MOSFETs in vernünftigen Grenzen geschalten werden. Für eine Nutzung des Tastverhältnisses $V_T$ über 50 % hinaus bis 100 % ist jedoch bei geforderter galvanischer Trennung z.B. eine Übertragung der Steuersignale über Lichtleitkabel mit entsprechender schalterseitiger Empfängerschaltung erforderlich.

In FIG. 12 ist beispielhaft eine Gruppe von vier in Reihe geschalteten MOSFETs 10-40 gezeigt, von denen nur der MOSFET 10 über eine Steuerleitung ST 10 direkt angesteuert wird, während die Ansteuerung der übrigen MOSFET 20-40 über einen RC-Spannungsteiler R50-R80, C20-C40 erfolgt. Der MOSFET 10 liegt dabei dem Minus-Bezugspotential der Reihenschaltung am Punkt P 10 am nächsten, während der MOSFET 40 dem Plus-Bezugspotential der Reihenschaltung am Punkt P20 am nächsten liegt. Zur Strombegrenzung werden die Gate-Elektroden der einzelnen MOSFETs 10-40 jeweils an einen Strombegrenzungswiderstand R10-R40 angeschlossen. Außerdem sind Zenerdioden Z10-Z40 vorgesehen, die jeweils die Source-Elektrode des zugeordneten MOSFETs 10-40 mit dessen Gate-Elektrode verbinden.

Der RC-Spannungsteiler besteht aus einer Reihenschaltung von vorzugsweise gleichen Widerständen R50-R80 und aus einer Parallelschaltung von Kondensatoren C20-C40, die mit ihrem einen Ende jeweils an das Minus-Bezugspotential der MOSFET-Reihenschaltung angeschlossen sind und mit ihrem anderen Ende jeweils an einen der Verbindungspunkte P11-P13 zwischen den Widerständen R50-R80 des RC-Spannungsteilers. Die Kapazitäten der Kondensatoren bestimmen sich dabei gemäß der Gleichung

$$C_n = \frac{1}{n} \cdot C_1 \text{ mit } n = 1, 2 \qquad (2)$$

wobei $C_1$ die Kapazität des Kondensators C20 ist, $C_2$ die des Kondensators C30 und $C_3$ die des Kondensators $C_{40}$.

An den beiden Enden der Widerstands-Reihenschaltung R50-R80 ist jeweils eine Hilfsspannungsquelle B1 und B2 mit ihrem positiven Pol angeschlossen, während der negative Pol der Hilfsspannungsquelle B1 an das Minus-Bezugspotential P10 und der der Hilfsspannungsquelle B2 an das Plus-Bezugspotential P20 der MOSFET-Reihenschaltung angeschlossen sind.

In FIG. 13 ist eine zur Schaltung in FIG. 12 äquivalente Schaltung gezeigt, deren einziger Unterschied darin besteht, daß anstelle der parallel geschalteten Kondensatoren der FIG. 12 nunmehr eine Reihenschaltung von Kondensatoren C20-C40 vorgesehen ist, deren Kapazitäten sich gemäß der Gleichung

$$C_n = n \cdot C_1 \text{ mit } n = 1, 2 \qquad (3)$$

bestimmen, wobei $C_1$ die Kapazität des Kondensators C40, $C_2$ die des Kondensators $C_{30}$ und $C_3$ die des Kondensators C10 ist.

Die beiden Hilfsspannungsquellen B1 und B2 sind erforderlich, um eine möglichst niedrige Restspannung an den durchgeschalteten MOSFETs 10-40 zu erreichen. Die Durchlaßspannung eines MOSFETs beträgt typisch weniger als 6V. Die dafür erforderliche Gate-Spannung beträgt aber typisch 10V. Ohne Hilfsspannungsquellen würde sich statisch eine Restspannung an jeden MOSFET 10-40 in Höhe der erforderlichen Gate-Spannung, also 10V, einstellen. Mit zwei 10V-Hilfsspannungsquellen dagegen ist die Restspannung statisch nur abhängig vom Strom und vom Durchlaßwiderstand $R_{ON}$ der MOSFETs 10-40.

Die statische Aufteilung der Sperrspannung ist abhängig von den Widerständen R50-R80 des RC-Spannungsteilers. Besteht der Spannungsteiler aus gleichen Widerständen R50-R80 und sind die Sperrwiderstände der MOSFETs 10-40 hoch, dann ist die Sperrspannungsaufteilung an den MOSFETs 10-40 im Idealfall gleich.

Weist ein MOSFET, z.B. MOSFET 20 in FIG. 12, einen niedrigen Sperrwiderstand auf oder ist durchlegiert, dann nimmt die Sperrspannung des fehlerhaften MOSFETs 20 und die der potentialmäßig darüber liegenden MOSFETs 30 und 40 ab. Im Extremfall teilt sich die Sperrspannung nur über die potentialmäßig darunter liegenden MOSFETs (hier also MOSFET 10) auf, was zu einer Zerstörung der Bauelemente führen kann.

Da bei der Zerstörung eines MOSFETs auch der Gate-Anschluß eine niederohmige Verbindung zum Drain- und Source-Anschluß des Bauelements aufweist, kann die Gate-Source-Spannung nicht umgepolt werden und es besteht keine Möglichkeit, bei Drain-Source-Kurzschluß eines MOSFETs durch Messung und Auswertung der Gate-Spannung die potentialmäßig darüber liegenden MOSFETs durch Kurzschluß des zugehörigen Widerstands im Spannungsteiler sperrfähig zu machen.

Um einen MOSFET schnell ein- und ausschalten zu können, müssen entsprechend schnell die Kapazitäten $C_{GS}$ und $C_{GD}$ umgeladen werden. Die Gate-Spannung ändert sich dabei aber nur in dem Bereich, der zur vollständigen Einschaltung oder Sperrung des Bauelements erforderlich ist (z.B. 5-10V). In diesem Spannungsbereich ist die Kapazität $C_{GS}$ aber bedeutend größer als üblicherweise im Datenblatt eines solchen MOSFETs für $U_{GS} = 0V$ angegeben. Darüber hinaus ist die Kapazität $C_{GD}$ eines MOSFETs spannungsabhängig. Zwar kann ein MOSFET mit relativ geringem Steuerstrom eingeschaltet werden, um jedoch die in dem Datenblatt des Bauelements spezifizierten Restspannung zu erreichen, muß der Steuerstrom i.a. um mehr als 50 % erhöht werden.

Das Auf- und Entladen der Kapazitäten $C_{GS}$ und $C_{GD}$ eines MOSFETs erfolgt durch einen nach Minus-Bezugspotential geschalteten äußeren Kondensator. Wird der Stromfluß zum Minus-Bezugspotential unterbrochen, dann fließt der Strom über $C_{GD}$ und $C_{GS}$ zu dem äußeren Kondensator, dessen Kapazität dabei so gewählt sein muß, daß eine ausreichende Umladung von $C_{GD}$ und $C_{GS}$ möglich ist.

Diesem äußeren Kondensator entsprechen in den Figuren 12 und 13 die Kondensatoren C20-C40. Wird in diesen Ausführungsbeispielen der potentialmäßig dem Minus-Bezugspotential P10 am nächsten liegende MOSFET 10 durch einen über die Steuerleitung ST10 übertragenen Steuerimpuls von der externen Steuerschaltung (8 in FIG. 3) eingeschaltet, dann fließt der Strom aus den äußeren Kondensatoren C20-C40 des RC-Spannungsteilers über die Transistor-Kapazitäten $C_{GS}$ und $C_{GD}$ der übrigen MOSFETs 20-40 der MOSFET-Reihenschaltung und schaltet dadurch die gesamte MOSFET-Kette 10-40 ein.

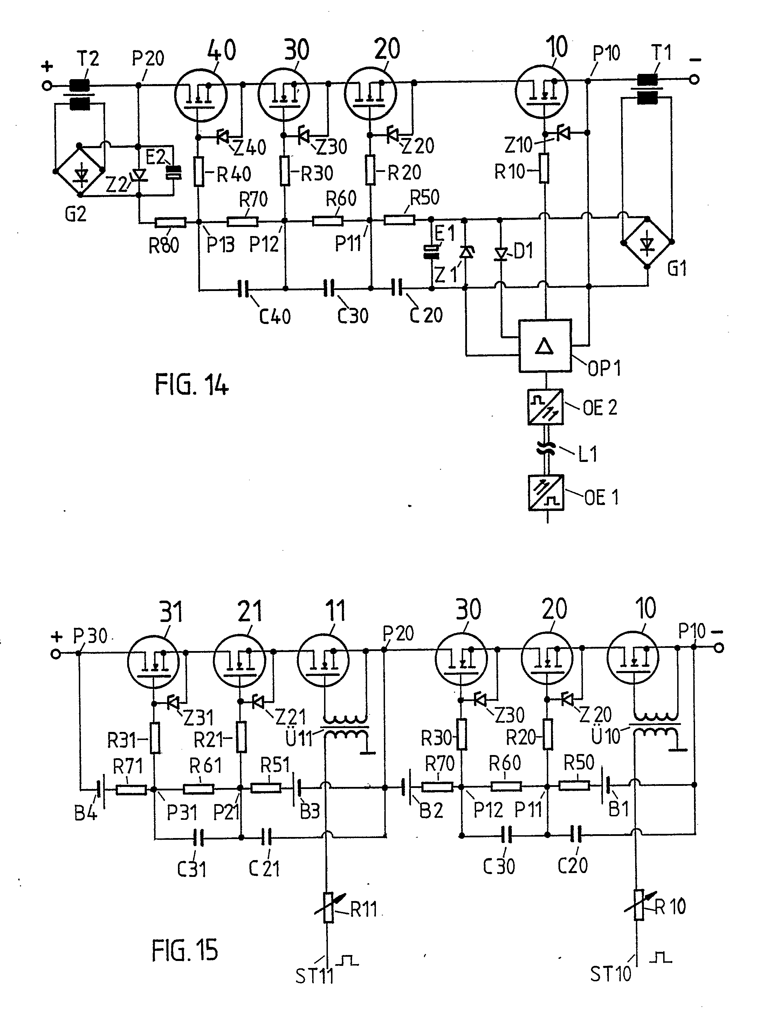

Nach der Gleichung (2) bzw. (3) ist die Kapazität der Kondensatoren C20-C40 davon abhängig, mit welchen der MOSFETs 10-40 sie verbunden sind und wie sie gegen das Minus-Bezugspotential P10 der Transistorkette geschaltet sind. Die Funktion der beiden Schaltungen in FIG. 12 und 13 ist im übrigen gleich. Eine vorteilhafte Ausführungsform der Schaltung gemäß FIG. 13 ist in FIG. 14 gezeigt.

Die an dem Plus-Bezugspotential P20 angeschlossene Hilfsspannungsquelle B1 der FIG. 13 ist in FIG. 14 in Form eines Stromwandlers T2 mit nachgeschalteter Gleichrichteranordnung G2 realisiert, der eine mit einem Kondensator E2 überbrückte Zenerdiode Z2 nachgeschaltet ist.

Die an dem Minus-Bezugspotential P10 angeschlossene Hilfsspannungsquelle B1 ist ebenfalls in Form einer Zenerdiode Z1 realisiert, die durch einen Kondensator E1 überbrückt ist. Da in diesem Ausführungsbeispiel die Ansteuerung des potentialmäßig dem Minus-Bezugspotential P10 am nächsten liegenden MOSFET 10 potentialfrei erfolgt (hier beispielhaft über ein Lichtleitkabel L1 mit vor- und nachgeschaltetem elektrooptischen Wandler OE1 und OE2), kann die Betriebsspannung für den Steuerbaustein OP1 nur anfangs aus dieser unteren Hilfsspannungsquelle Z1, E1 entnommen werden, die bei Anlegen der zu schaltenden Hochspannung wirksam wird, so daß ein Schalten der MOSFET-Reihenschaltung 10-40 kurzzeitig möglich ist. Die weitere Versorgung erfolgt dann über einen Stromwandler T1 mit nachgeschalteter Gleichrichteranordnung G1.

Der Vorteil einer solchen Schaltung ist vor allem in dem geringen Aufwand für die Ansteuerung zu sehen, da mehrere MOSFET (20-40 in FIG. 12-14) von einem einzigen MOSFET (10 in FIG. 12-14) gesteuert werden, wodurch sich der Schaltungsaufwand für den erfindungsgemäßen Hochspannungsschalter erheblich verringert. In der Praxis ist die Anzahl der in Reihe schaltbaren MOSFETs mit den derzeit erhältlichen Bauelementen ohne zusätzlichen Aufwand (z.B. in Form von Treiberschaltungen) auf ca. 10-15 beschränkt, weil sonst die Summe der Steuerströme größer wird als der zu schaltende Drain-Strom.

Insgesamt sind mit den in den Figuren 11-14 gezeigten Ausführungsbeispielen der erfindungsgemäßen Ansteuerung von in Reihe geschalteten MOSFETs in etwa gleiche Schaltzeiten realisierbar, so daß die in diesen Beispielen beschriebenen unterschiedlichen Arten der Ansteuerung vorteilhaft ohne weiteres miteinander kombiniert werden können, wie das das Ausführungsbeispiel in FIG. 15 zeigt.

Dort sind beispielhaft zwei hintereinandergeschaltete Gruppen von jeweils drei in Reihe geschalteten MOSFETs 10-30 bzw. 11-31 gezeigt, von denen jeweils der potentialmäßig dem Minus-Bezugspotential P10 bzw. P20 der jeweiligen Gruppe am nächsten liegende MOSFET 10 bzw. 11 über eine Steuerleitung ST10 bzw. ST11 von der (nicht gezeigten) externen Steuerschaltung (8 in FIG. 3) angesteuert wird. In den beiden Steuerleitungen ist jeweils ein Impulsübertrager Ü10 bzw. U11 zur galvanischen Trennung, ein in seinem Wert variabel einstellbarer Widerstand R10 bzw. R11 und gegebenenfalls auch ein (nicht gezeigtes) Zeitverzögerungsglied enthalten, so daß dieser Teil der Schaltung vergleichbar ist mit der Ansteuerung eines MOSFETs in der Schaltung gemäß FIG. 11. Die übrigen MOSFETs 20-30 bzw. 21-31 der beiden Gruppen werden jedoch wie in den Schaltungen gemäß FIG. 13 und 14 über einen RC-Spannungsteiler angesteuert.

Die in FIG. 11 und 15 gezeigten Impulsüberträger sind aufgrund der Ummagnetisierung i.a. nur bis zu einer Aussteuerung von etwa 50 % bzw. zu einem Tastverhältnis von etwa 1:1 ($V_T \approx 0.5$) einsetzbar, was bei den Anwendungen mit Modulationen bis zu 100 % wie z.B. bei einem Modulationsverstärker für einen Rundfunksender nicht ausreicht. In diesen Fällen müssen Übertragungssysteme verwendet werden, die eine statische Einstellung der Modulationsverstärkerausgangsspannung $U_A$ zwischen 0 und 100 % erlauben, was einem Variationsbereich für $V_T$ von 0 bis 1 entspricht. Dies können z.B. Übertragungssysteme sein, bei denen die Übertragung der Steuerimpulse über Lichtleitkabel oder über Trägerfrequenz erfolgt.

Zur Realisierung eines 30-kV-Hochspannungsschalters müssen unter Berücksichtigung eines ausreichenden Sicherheitsfaktors etwa 60-70 800-V-MOSFET in Reihe geschaltet werden. Mit der erfindungsgemäßen Ansteuerung können diese MOSFETs in 6-7 Gruppen mit jeweils 10 MOSFETs unterteilt werden, von denen jeweils 9 durch einen RC-Spannungsteiler angesteuert werden, während der potentialmäßig jeweils am niedrigsten liegende MOSFET jeder Gruppe über Lichtleitkabel, Trägerfrequenz oder mit Nadelimpulsen von der externen Steuerschaltung (8 in FIG. 3) angesteuert wird, so daß insgesamt nur sieben Steuerkanäle für siebzig MOSFET benötigt werden.

Aus Gründen der Sicherheit und Zuverlässigkeit ist es von Vorteil, die Funktionsfähigkeit der Hochspannungsschalter während des Betriebs fortlaufend zu überwachen, um bei einer Fehlfunktion sofort entsprechende Sicherungsmaßnahmen ergreifen zu können.

Erfindungsgemäß wird hierzu der potentialmäßig am höchsten liegende MOSFET jeder Gruppe auf seinen Schaltzustand hin überwacht, da bei Ausfall eines MOSFETs innerhalb dieser Gruppe dieser MOSFET immer mit betroffen ist.

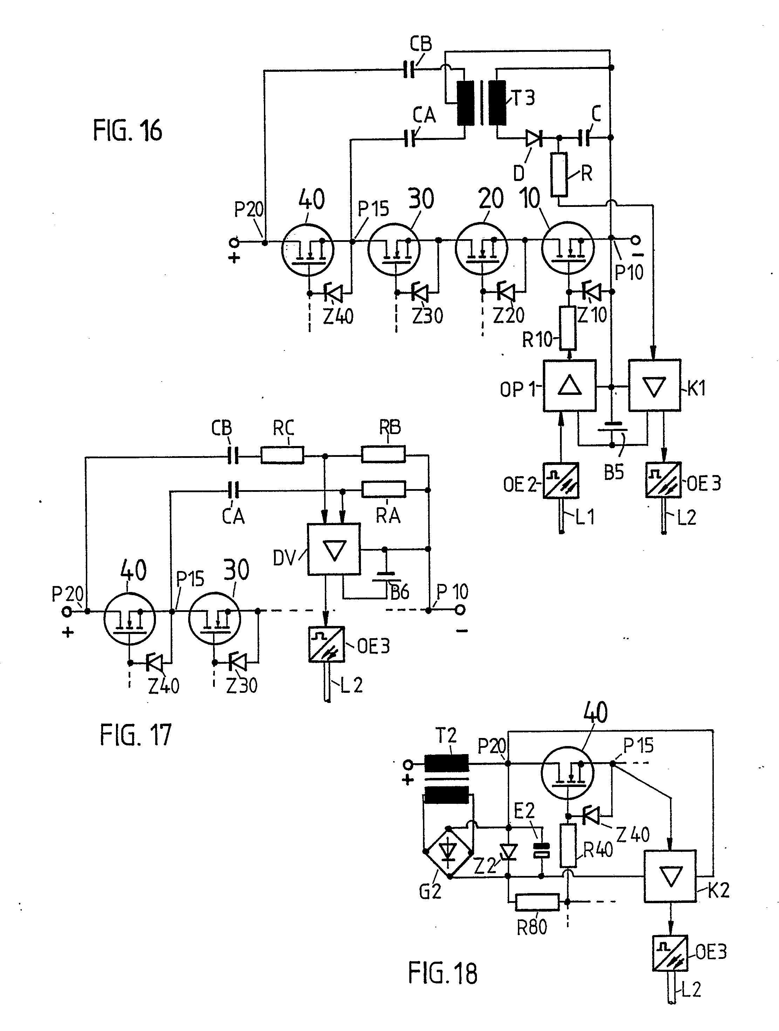

Ausführungsbeispiele von solchermaßen in die einzelnen Gruppen integrierten Überwachungseinrichtungen sind in den Figuren 16 bis 18 gezeigt.

FIC. 16 zeigt eine zu überwachende Gruppe von vier in Reihe geschalteten MOSFET 10-40, deren (nicht vollständig gezeigte) Ansteuerung beispielsweise der Ansteuerung gemäß FIG. 14 entspricht und u.a. ein Lichtleitkabel L1 mit nachgeschalteten elektrooptischem Wandler OE 2 zur Übertragung der Steuerimpulse enthält sowie einen Steuerbaustein OP1, der über einen Strombegrenzungswiderstand R10 an die Gate-Elektrode des dem Minus-Bezugspotential P10 am nächsten liegenden MOSFET 10 angeschlossen ist und der durch eine Hilfsspannungsquelle B5 versorgt wird.

Die erfindungsgemäße Überwachungseinrichtung ist mit jeweils einem ihrer beiden Eingänge an den Anschlußpunkten P20 bzw. P15 an die Drain- bzw. Source-Elektrode des potentialmäßig dem Plus-Bezugspotential am nächsten liegenden MOSFET 40 angeschlossen. Die Eingänge sind über Kondensatoren CA bzw. CB mit den Enden der Primärwicklung eines Übertragers T3 verbunden, dessen Mittenabgriff mit dem Minus-Bezugspotential P10 der MOSFET-Reihenschaltung verbunden ist. Die Sekundärwicklung des Übertragers T3 ist mit ihrem einem Ende direkt und mit ihrem anderem Ende über eine Reihenschaltung aus Diode D und Kondensator C ebenfalls mit dem Minus-Bezugspotential P10 verbunden. Zwischen Diode D und Kondensator C ist ein Abgriff vorgesehen, der über einen Widerstand R mit einem Komparator K1 verbunden ist, der ebenfalls durch die Hilfsspannungsquelle B5 versorgt wird.

Der Komparator K1 ist ausgangsseitig mit einem elektrooptischen Wandler OE3 verbunden, dessen Ausgang über ein zweites Lichtleitkabel L2 mit einer (nicht gezeigten) Auswerteeinheit in der Steuerschaltung (8 in FIG. 3) ver bunden ist.

Die erfindungsgemäße Überwachungseinrichtung in FIG. 17 unterscheidet sich von der Einrichtung in FIG. 16 dadurch, daß der Kondensator CB über eine Widerstands-Reihenschaltung RB, RC und der Kondensator CA über einen Widerstand RA mit dem Minus-Bezugspotential P10 der MOSFET-Reihenschaltung verbunden ist. Zwischen dem Kondensator CA und dem Widerstand RA sowie zwischen den beiden Widerständen RB und RC sind Abgriffe vorgesehen, die mit den Eingängen eines Differenzverstärkers DV verbunden sind, der durch eine Hilfsspannungsquelle B6 versorgt wird. Ausgangsseitig ist der Differenzverstärker DV wieder mit einem elektrooptischem Wandler OE3 verbunden, dessen Ausgang über ein zweites Lichtleitkabel mit der (nicht gezeigten) Auswerteeinheit verbunden ist.

Eine dritte Ausführungsform der erfindungsgemäßen Überwachungseinrichtung ist in FIG. 18 gezeigt. Sie besteht im wesentlichen aus einem Komparator K2, der eingangsseitig an die Source-Elektrode des dem Plus-Bezugspotenital P20 der MOSFET-Reihenschaltung potentialmäßig am nächsten liegenden MOSFET 40 angeschlossen ist und der durch die in FIG. 14 detailliert gezeigte Hilfsspannungsquelle B2 versorgt wird, die in Form eines Stromwandlers T2 mit nachgeschalteter Gleichrichteranordnung G2 der eine mit einem (Elko-)Kondensator E2 überbrückte Zenerdiode Z2 nachgeschaltet ist, realisiert ist.

Ausgangsseitig ist der Komparator K2 wieder mit einem elektrooptischem Wandler OE3 verbunden, dessen Ausgang über ein zweites Lichtleitkabel L2 mit der (nicht gezeigten) Auswerteeinheit verbunden ist.

Bei den erfindungsgemäßen Ansteuerungen gemäß FIG. 12-14 mit einem RC-Spannungsteiler R50-R80, C20-C40, ist eine einwandfreie Sperrung der Transistoren und eine damit verbundene angenähert gleiche Sperrspannungsaufteilung bei den in Reihe geschalteten MOSFETs 10-40 nur gegeben, wenn der Sperrwiderstand (Drain-Source) jedes Transistors 10-40 bedeutend höher ist als der Widerstandswert des RC-Spannungsteilers R50-R80, C20-C40. Ist dies nicht der Fall oder ist im Extremfall ein beliebiger Transistor der MOSFET-Reihenschaltung durchlegiert, dann ist die am obersten Transistor der Kette beim Schalten meßbare Wechselspannung bedeutend niedriger als normal. Diese Spannung wird durch Messung gegen das Minus-Bezugspotential P10 der Kette und Differenzbildung ausgewertet. Sind in FIG. 16 die Kondensatoren $C_A$ und $C_B$ gleichgroß, dann heben sich bei Ausfall eines Transistors die über die Kondensatoren (CA bzw. CB) fließenden Ströme im Übertrager T3 auf und die sekundärseitige Spannung ist null. In der Praxis nimmt die Spannung um ca. 30-50 % ab. In FIG. 17 wird die am Drainanschluß des obersten Transistors 40 gemessene Spannung hinter dem Kondensator CB derart geteilt, daß zwischen RB und RC eine Spannung meßbar ist, die dem Wert entspricht, der sich bei Messung der Drainspannung des vorletzten Transistors 30 hinter dem Kondensator CA an RA einstellt. Im Idealfall ist die Differenzspannung null. Bei Ausfall eines Transistors in der MOSFET-Reihenschaltung ist die Differenzspannung ungleich null und der angeschlossene Differenzverstärker DV kann eine Fehlermeldung abgeben, die, wie in FIG. 16, über den elektroopischen Wandler OE3 und das Lichtleitkabel L2 (oder alternativ hierzu über einen Impulsübertrager mittels Trägerfrequenz) zur Auswerteeinheit in der Steuerschaltung, die z.B. auf Erdpotential liegt übertragen wird.

In FIG. 18 wird die Schaltspannung des obersten Transistors 40 direkt von einem Komperator K2 ausgewertet, der bei Unterschreitung einer Schwelle eine zu kleine Schaltspannung z.B. über den elektrooptischen Wandler OE3 und Lichtleitkabel L2 (oder alternativ hierzu über einen Impulsübertrager mittels Trägerfrequenz) der Auswerteeinheit in der Steuerschaltung meldet.

Die Überwachungsschaltungen für die einzelnen MOSFET-Gruppen können jeweils von der gleichen Hilfsspannungsquelle (B1 in den Figuren 12 und 13) versorgt werden, mit der auch der Signalempfänger (OP1 in FIG. 14) zur Ansteuerung des potentialmäßig am niedrigsten liegenden MOSFET (10 in den Figuren 13-15) betrieben wird.

Die Hilfsspannungsquelle kann dabei - wie weiter oben diskutiert - beim Einschalten aus dem Widerstandteiler gespeist werden und anschließend aus einem Stromwandler. Die Fehlerrückmeldung kann zur weiteren Auswertung z.B. über Lichtleitkabel, Trägerfrequenz oder Impulsübertrager nach Erdpotential übertragen werden. Es versteht sich, daß die Erfindung mit fachmännischem Können aus- und weitergebildet werden kann bzw. an die unterschiedlichen Anwendungen angepaßt werden kann, ohne daß dies hier näher erläutert werden muß.

So ist es z.B. denkbar, zur Übertragung der Steuerimpulse und der Fehlerrückmeldungsignale jeweils ein gemeinsames Lichtleitkabel vorzusehen, an dessen Enden jeweils ein Sender und Empfänger angeordnet ist, wobei vorzugsweise unterschiedliche Lichtwellenlängen für die Übertragung der Steuerimpulse einerseits und der Fehlerrückmeldungssignale andererseits verwendet werden.

Weiterhin ist es von Vorteil, bei der Festlegung der Anzahl der erforderlichen Gruppen Redundanz vorzusehen, so daß der Hochspannungsschalter auch bei Ausfall einer Gruppe weiter betrieben werden kann, da i.a. bei Ausfall eines MOSFET dieser niederohmig, d.h. leitend wird und nicht hochohmig, d.h. sperrend, so daß der Stromfluß hierdurch nicht unterbrochen wird.

Schließlich ist es denkbar, die Steuerung der MOSFETs bzw. die Auswertung der Fehlerrückmeldungsignale von einem Mikroprozessor o.ä. durchführen zu lassen.


**Ansprüche**

1. Modulationsverstärker für hohe Spannungen, welcher aus einem Schaltverstärker und einem Tiefpaßfilter besteht, welcher Schaltverstärker eine Hochspannungsgleichstromversorgung, einen ersten Hochspannungsschalter, eine Freilaufdiode sowie eine Steuerschaltung enthält, welche Steuerschaltung Steuerimpulse zum Schalten des Hochspannungsschalters erzeugt, die von dem zu verstärkenden Modulationssignal abgeleitet sind, und welches Tiefpaßfilter eine Speicherdrossel und einen Siebkondensator enthält, dadurch gekennzeichnet, daß der erste Hochspannungsschalter (1) aus mehreren in Reihe und/oder parallel geschalteten Halbleiterschaltern (10-40) besteht.

2. Modulationsverstärker nach Anspruch 1, dadurch gekennzeichnet, daß parallel zur Freilaufdiode (4) ein im Gegen takt zu dem ersten Hochspannungsschalter (1) arbeitender zweiter Hochspannungsschalter (2) geschaltet ist und daß dieser zweite Hochspannungsschalter (2) ebenfalls aus mehreren in Reihe und/oder parallel geschalteten Halbleiterschaltern (10-40) besteht.

3. Modulationsverstärker nach Anspruch 2, dadurch gekennzeichnet, daß die Totzeiten zwischen Öffnen (Schließen) des ersten Hochspannungsschalters (1) und Schließen (Öffnen) des zweiten Hochspannungs-Schalters (2) in Abhängigkeit von dem zu schaltenden Strom variabel einstellbar sind.

4. Modulationsverstärker nach einem der Ansprüche 2 bis 3, dadurch gekennzeichnet, daß mit dem zweiten Hochspannungsschalter (2) ein Widerstand (9) in Reihe geschaltet ist und daß der zweite Hochspannungsschalter (2) dabei vorzugsweise mit einem Ende direkt an Masse angeschlossen ist.

5. Modulationsverstärker nach einem der Ansprüche 1 bis 4, dadurch gekennzeichnet, daß in dem ersten (und dem zweiten) Hochspannungsschalter (1, 2) Einrichtungen zur Überwachung der Schalterfunktion und zur Fehlermeldung an die Steuerschaltung (8) vorgesehen sind.

6. Modulationsverstärker nach einem der Ansprüche 1 bis 5, dadurch gekennzeichnet, daß die Steuerschaltung pulsfrequenzmodulierte Steuerimpulse mit konstanter Impulsdauer erzeugt.

7. Modulationsverstärker nach einem der Ansprüche 1 bis 5, dadurch gekennzeichnet, daß die Steuerschaltung pulsdauermodulierte Steuerimpulse mit konstanter Schaltfrequenz erzeugt.

8. Modulationsverstärker nach einem der Ansprüche 1 bis 7, dadurch gekennzeichnet, daß zu jedem Halbleiterschalter (10-40) des ersten (und des zweiten) Hochspannungsschalters (1, 2) jeweils eine Steuerleitung (ST10-ST40) der Steuerschaltung führt.

9. Modulationsverstärker nach einem der Ansprüche 1 bis 7, dadurch gekennzeichnet, daß die Halbleiterschalter (10-40) des ersten (und des zweiten) Hochspannungsschalters (1, 2) (jeweils) in Gruppen zusammengefaßt sind und daß zu jeder Gruppe jeweils nur eine Steuerleitung (ST 10) der Steuerschaltung führt.

10. Modulationsverstärker nach Anspruch 9, dadurch gekennzeichnet, daß die einzelnen Gruppen jeweils mindestens zwei direkt hintereinander in Reihe geschaltete Halbleiterschalter (10-40) enthalten.

11. Modulationsverstärker nach einem der Ansprüche 8 bis 10, dadurch gekennzeichnet, daß die Steuerschaltung (8) galvanisch von dem ersten (und dem zweiten) Hochspannungsschalter (1, 2) getrennt ist.

12. Modulationsverstärker nach Anspruch 11, dadurch gekennzeichnet, daß die einzelnen Steuerleitungen jeweils einen Impulsübertrager zur galvanischen Trennung enthalten.

13. Modulationsverstärker nach Anspruch 11, dadurch gekennzeichnet, daß die einzelnen Steuerleitungen zur galvanischen Trennung jeweils einen aus einem Lichtleitkabel bestehenden Abschnitt enthalten und daß an den beiden Enden eines solchen Lichtwellenleiters jeweils ein elektrooptischer Wandler vorgesehen ist.

14. Modulationsverstärker nach einem der Ansprüche 1 bis 13, dadurch gekennzeichnet, daß die einzelnen Halbleiterschalter (10-40) jeweils Static-Induction-Transistoren sind.

15. Modulationsverstärker nach einem der Ansprüche 1 bis 13, dadurch gekennzeichnet, daß die einzelnen Halbleiterschalter (10-40) jeweils MOS-Feldeffekttransistoren (MOSFET) sind.

16. Modulationsverstärker nach den Ansprüchen 8, 12 und 15, dadurch gekennzeichnet, daß jeder der Impulsübertrager (Ü10-Ü40) in den einzelnen Steuerleitungen (ST10-ST40) jeweils mit dem einen Ende seiner Sekundärwicklung an die Gate-Elektrode und mit dem anderen Ende seiner Sekundärwicklung an die Source-Elektrode des zugehörigen MOSFETS (10-40) angeschlossen ist und mit dem einen Ende seiner Primärwicklung an Masse und mit dem anderen Ende seiner Primärwicklung an die zugehörigen Steuerleitung (ST10-ST40) angeschlossen ist (FIG. 11).

17. Modulationsverstärker nach Anspruch 16, dadurch gekennzeichnet, daß zur Einstellung der Sperrspannungsaufteilung zwischen den einzelnen MOSFETs (10-40) in jeder Steuerleitung (ST10-ST40) jeweils zwischen Steuerschaltung (8) und Impulsübertrager (Ü10-Ü40) ein in seinem Wert variabel einstellbarer Widerstand (R10-R40) vorgesehen ist (FIG. 11).

18. Modulationsverstärker nach einem der Ansprüche 16 bis 17, dadurch gekennzeichnet, daß zur

11

Synchronisierung der Schaltzeitpunkte der einzelnen MOSFETs (10-40) in jeder Steuerleitung (ST10-ST40) jeweils ein variabel einstellbares Zeitverzögerungsglied vorgesehen ist.

19. Modulationsverstärker nach einem der Ansprüche 10 bis 13 und Anspruch 15, dadurch gekennzeichnet, daß die zu den einzelnen Gruppen führenden Steuerleitungen (ST10) jeweils mit der Gate-Elektrode des dem Minus-Bezugspotential (P10) der MOSFET-Reihenschaltung (10-40) potentialmäßig am nächsten liegenden ersten MOSFETs (10) der MOSFET-Reihenschaltung (10-40) der ihnen jeweils zugeordneten Gruppe verbunden sind und daß die Steuerung der übrigen MOSFETs (20-40) dieser MOSFET-Reihenschaltung (10-40) jeweils über einen RC-Spannungsteiler (R50-R80, C20-C40) erfolgt (FIG. 12, FIG. 13).

20. Modulationsverstärker nach Anspruch 19, dadurch gekennzeichnet, daß für den Fall der galvanischen Trennung von Steuerschaltung und Hochspannungsschalter durch Impulsübertrager in den einzelnen Steuerleitungen die Impulsübertrager (Ü10; Ü11) in den zu den einzelnen Gruppen (10-30; 11-31) führenden Steuerleitungen (ST10; ST11) jeweils mit dem einen Ende ihrer Sekundärwicklung an die Gate-Elektrode und mit dem anderen Ende ihrer Sekundärwicklung an die Source-Elektrode des ersten MOSFETs (10; 11) der ihnen jeweils zugeordneten Gruppe (10-30; 11-31) angeschlossen sind und mit dem einen Ende ihrer Primärwicklung an Masse und mit dem anderen Ende ihrer Primärwicklung an die Steuerschaltung angeschlossen sind (FIG. 15).

21. Modulationsverstärker nach Anspruch 20, dadurch gekennzeichnet, daß zur Einstellung der Sperrspannungsaufteilung zwischen den einzelnen Gruppen (10-30, 11-31) in den einzelnen Steuerleitungen (ST10; ST11) jeweils zwischen Steuerschaltung und Impulsübertrager (Ü10; Ü11) ein in seinem Wert variabel einstellbarer Widerstand (R10; R11) vorgesehen ist (FIG. 15).

22. Modulationsverstärker nach einem der Ansprüche 20 bis 21, dadurch gekennzeichnet, daß zur Synchronisierung der Schaltzeitpunkte der einzelnen Gruppen (10-30; 11-31) in den einzelnen Steuerleitungen (ST10; ST11) jeweils ein variabel einstellbares Zeitverzögerungsglied vorgesehen ist.

23. Modulationsverstärker nach einem der Ansprüche 19 bis 22, dadurch gekennzeichnet,
- daß der RC-Spannungsteiler (R50-R80, C20-C40) mehrere in Reihe geschaltete Widerstände (R50-R80) enthält;
- daß die Zahl der Widerstände (R50-R80) der Zahl der in Reihe geschalteten MOSFETs (10-40) entspricht;
- daß die in Reihe geschalteten übrigen MOSFETs (20-40) mit ihren Gate-Elektroden so an die Verbindungspunkte (P11-P13) zwischen den in Reihe geschalteten Widerstände (R50-R80) angeschlossen sind, daß sich zwischen den Gate-Elektroden direkt benachbarter MOSFETs (20, 30; 30, 40) jeweils ein Widerstand (R60; R70) der Widerstands-Reihenschaltung (R50-R80) befindet (FIG. 12, FIG. 13).

24. Modulationsverstärker nach Anspruch 23, dadurch gekennzeichnet,
- daß an den beiden Enden der Widerstands-Reihenschaltung (R50-R80) jeweils eine Hilfsspannungsquelle (B1; B2) mit ihrem positiven Pol angeschlossen ist;
- daß die eine Hilfsspannungsquelle (B1) mit ihrem negativen Pol an das Minus-Bezugspotential (P10) und die andere Hilfsspannungsquelle (B2) mit ihrem negativen Pol an das Plus-Bezugspotential (P20) der zugehörigen MOSFET-Reihenschaltung (10-40) angeschlossen sind (FIG. 12, FIG. 13).

25. Modulationsverstärker nach einem der Ansprüche 23 bis 24, dadurch gekennzeichnet,
- daß an den Verbindungspunkten (P11-P13) zwischen den in Reihe geschalteten Widerständen (R50-R80) des RC-Spannungsteilers (R50-R80, C20-C40) jeweils ein einseitig an das Minus-Bezugspotential (P10) der zugehörigen MOSFET-Reihenschaltung (10-40) angeschlossener Kondensator (C20-C40) angeschlossen ist;
- daß die Kapazitäten dieser Kondensatoren (C20-C40), ausgehend von der Kapazität $C_1$ des an den dem Minus-Bezugspotential (P10) am nächsten liegenden Verbindungs punkt (P11) angeschlossenen Kondensators (C20), gemäß der Beziehung $C_n = \frac{1}{n} \cdot C_1$ mit $n = 1, 2, \ldots$ sukzessive abnimmt (FIG. 12).

26. Modulationsverstärker nach einem der Ansprüche 23 bis 24, dadurch gekennzeichnet,
- daß mit Ausnahme des dem Plus-Bezugspotential (P20) der zugehörigen MOSFET-Reihenschaltung (10-40) am nächsten liegendenWiderstands (R80) den einzelnen Widerständen (R50; R60; R70) der Widerstands-Reihenschaltung (R50-R80) des RC-Spannungsteilers (R50-R80 , C20-C40) jeweils ein Kondensator (C20; C30; C40) einer Kondensator-Reihenschaltung (C20-C40) parallel geschaltet ist;
- daß die Kapazitäten dieser Kondensatoren (C20-C40), ausgehend von der Kapazität $C_1$ des an dem Plus-Bezugspotential (P20) der zugehörigen MOSFET-Reihenschaltung (10-40) am nächsten liegenden Verbindungspunkt (P13) der Widerstand-Reihenschaltung (R50-R80) angeschlossenen Kondensators (C40), gemäß der Beziehung $C_n = n \cdot C_1$ mit $n = 1, 2, \ldots$ sukzessive zunimmt (FIG. 13).

27. Modulationsverstärker nach einem der Ansprüche 15 bis 26, dadurch gekennzeichnet, daß der Gate-Elektrode eines jeden MOSFETs (10-40) jeweils ein Strombegrenzungswiderstand (R10-R40) vorgeschaltet ist (FIG. 12, FIG. 13, FIG. 14).

28. Modulationsverstärker nach Anspruch 5 und einen der Ansprüche 19 bis 27, dadurch gekennzeichnet,

- daß jede Gruppe von Halbleiterschaltern (10-40) jeweils eine Überwachungseinheit aufweist und daß eine solche Überwachungseinheit einen einen primärseitigen Mittenabgriff aufweisenden Übertrager (T3) aufweist;

- daß die Primärwicklung des Übertragers (T3) mit dem einem Ende über einen zweiten Kondensator (CB) mit dem Plus-Bezugspotential (P20) der Gruppe und mit dem anderem Ende über einen ersten Kondensator (CA) mit dem Verbindungspunkt (P15) zwischen dem potentialmäßig dem Plus-Bezugspotential (P20) am nächsten und dem diesem Bezugspotential (P20) am zweitnächsten liegenden Halbleiterschalter (40 bzw. 30) sowie mit dem Mittenabgriff mit dem Minus-Bezugspotential (P10) der Gruppe verbunden ist;

- daß die Sekundärwicklung des Übertragers (T3) mit dem einem Ende über eine Reihenschaltung aus einer Diode (D) und einem dritten Kondensator (C) und mit dem anderem Ende direkt an das Minus-Bezugspotential (P10) der Gruppe angeschlossen ist;

- daß zwischen Diode (D) und Kondensator (C) ein Abgriff vorgesehen ist und daß dieser Abgriff über einen Widerstand (R) mit dem Eingang eines Komparators (K1) verbunden ist;

- daß der Komparator (K1) ausgangsseitig vorzugsweise über Lichtleitkabel (L2) mit einer Auswerteeinheit in der Steuerschaltung verbunden ist (FIG. 16).

29. Modulationsverstärker nach Anspruch 5 und einen der Ansprüche 19 bis 27, dadurch gekennzeichnet,

- daß jede Gruppe von Halbleitschaltern (10-40) jeweils eine Überwachungseinheit aufweist und daß eine solche Überwachungseinheit eine erste Reihenschaltung aus erstem Kondensator (CA) und einem ersten Widerstand (RA) und eine zweite Reihenschaltung aus zweitem Kondensator (CB) und einem zweiten und dritten Widerstand (RB, RC) enthält;

- daß die zweite Reihenschaltung (CB, RB, RC) das Plus-Bezugspotential (P20) mit dem Minus-Bezugspotential (P10) der Gruppe verbindet und daß die erste Reihenschaltung (CA, RA) den Verbindungspunkt (P15) zwischen den potentialmäßig dem Plus-Bezugspotential (P20) am nächsten und dem diesem Bezugspotential (P20) am zweitnächsten liegenden Halbleiterschalter (40 bzw. 30) mit dem Minus-Bezugspotential (P10) der Gruppe verbindet;

- daß zwischen erstem Kondensator (CA) und erstem Widerstand (RA) sowie zwischen zweitem und drittem Widerstand (RB, RC) jeweils ein Abgriff vorgesehen ist und daß diese Abgriffe mit den entsprechenden Eingängen eines Differenzverstärkers (DV) verbunden sind;

- daß der Differenzverstärker (DV) ausgangsseitig vorzugsweise über Lichtleitkabel mit der Auswerteeinheit in der Steuerschaltung verbunden ist (FIG. 14).

30. Modulationsverstärker nach Anspruch 5 und einen der Ansprüche 19 bis 27, dadurch gekennzeichnet,

- daß jede Gruppe von Halbleiterschaltern (10-40) jeweils eine solche Überwachungseinheit aufweist

- daß eine solche Überwachungseinrichtung für eine Gruppe von Halbleiterschaltern (10-40) einen weiteren Komparator (K2) aufweist,

- daß dieser weitere Komparator (K2) die Schaltspannung des dem Plus-Bezugspotential (P20) der Gruppe am nächsten liegenden Halbleiterschalters (40) direkt auswertet und bei Unterschreitung eines vorgesehenen Schwellenwertes ein Fehlersignal vorzugsweise über Lichtleitkabel an die Auswerteeinheit in der Steuerschaltung abgibt.

FIG. 1

FIG. 2

FIG. 3

a)

$U_A$ [KV]

30

15

0,5    1    $V_T$

b)

$U_A$ [KV]

30

15

t

c)

$U_A$

$U_{REST}$

$V_T$

d)

$U_A$

$U_{REST}$

t

FIG. 4

FIG. 5

FIG. 6

FIG. 7

FIG.8

FIG.9

FIG. 10

FIG. 11

FIG. 12

FIG. 13

FIG. 14

FIG. 15

FIG. 16

FIG. 17

FIG. 18

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 226 006 (LICENTIA) <br> * Seite 4, Zeile 3 - Seite 5, Zeile 15; Seite 7, Zeilen 17-28; Figuren 1,3 * | 1,7-10 | H 03 F 3/217 <br> H 03 K 17/10 <br> H 03 K 17/08 |
| Y | | 2-6,11-16,19, 20,23, 26,27, 30 | |
| | --- | | |
| Y | EP-A-0 266 551 (MONROE ELECTRONICS) <br> * Spalte 8, Zeilen 34-46; Figur 7 * | 2-4 | |
| | --- | | |
| Y | EP-A-0 141 427 (SIEMENS) <br> * Seite 7, Zeilen 11-33; Figuren 2a,2b * | 3 | |
| | --- | | |
| Y | PATENT ABSTRACTS OF JAPAN, Band 10, Nr. 283 (E-440)[2339], 26. September 1986; & JP-A-61 102 816 (HITACHI LTD) 21-05-1986 <br> * Figuren 1,2; Zusammenfassung * | 5,9,10, 15,19, 23,30 | |
| | --- | | RECHERCHIERTE SACHGEBIETE (Int. Cl.5) |
| A | IDEM | 28,29 | H 03 F <br> H 03 K <br> H 02 M |
| | --- | | |
| Y | US-A-3 184 615 (STOVER) <br> * Spalte 1, Zeilen 9-12; Figuren 1,3 * | 6 | |
| | --- | | |
| Y | US-A-3 526 787 (STOVER) <br> * Spalte 1, Zeilen 25-32; Spalte 5, Zeile 50 - Spalte 7, Zeile 59; Figuren 4-7 * | 11,12 | |
| | --- | | |
| Y | GB-A-1 269 502 (ENGLISH ELECTRIC CO. LTD) <br> * Seite 1, Zeilen 10-16; Seite 1, Zeile 66 - Seite 2, Zeile 6; Figur * | 11,13 | |
| | --- -/- | | |

Der vorliegende Recherchenbericht wurde für alle Patentansprüche erstellt

| Recherchenort | Abschlußdatum der Recherche | Prüfer |
|---|---|---|
| DEN HAAG | 13-10-1989 | CANTARELLI R.J.H. |

EPO FORM 1503 03.82 (P0403)

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
.......................................................
& : Mitglied der gleichen Patentfamilie, übereinstimmendes Dokument

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | DE-A-3 125 242 (K.K. MORITA SEISAKUSHO) <br> * Figur 4 * <br> --- | 14 | |
| Y | EP-A-0 215 707 (THOMSON-CSF) <br> * Spalte 3, Zeile 49 - Spalte 4, Zeile 55; Figuren 3,4 * <br> --- | 11,12, 15,16, 19,20, 23,26 | |
| Y | EP-A-0 140 349 (HITACHI LTD) <br> * Seite 10, Ziele 22 - Seite 11, Zeile 16; Figur 7 * <br> --- | 15,19, 23,24 | |
| Y | EP-A-0 048 758 (INTERNATIONAL RECTIFIER CORP.) <br> * Seite 11, Zeile 34 - Seite 12, Zeile 17; Figur 6 * | 15,19, 23,27 | |
| A | | 25 | |
| A | CH-A- 451 315 (BROWN & BOVERI) <br> * Spalte 2, Zeile 28 - Spalte 3, Zeile 17; Figur 2 * <br> ----- | 18,22 | RECHERCHIERTE SACHGEBIETE (Int. Cl.5) |

Der vorliegende Recherchenbericht wurde für alle Patentansprüche erstellt

| Recherchenort | Abschlußdatum der Recherche | Prüfer |
|---|---|---|
| DEN HAAG | 13-10-1989 | CANTARELLI R.J.H. |